# EUROPÄISCHE PATENTSCHRIFT

(11) **EP 3 583 247 B1**
(45) Veröffentlichungstag und Bekanntmachung des Hinweises auf die Patenterteilung: **09.09.2020**
(21) Anmeldenummer: 18705135.4
(22) Anmeldetag: 13.02.2018
(51) Int. Cl.: C30B 13/20, C30B 13/30, C30B 29/06

(54) **VERFAHREN UND ANLAGE ZUM ZIEHEN EINES EINKRISTALLS NACH DEM FZ-VERFAHREN**
METHOD AND SYSTEM FOR PULLING A MONOCRYSTAL IN ACCORDANCE WITH THE FZ METHOD
PROCÉDÉ ET INSTALLATION DE TIRAGE D'UN MONOCRISTAL SELON LE PROCÉDÉ DE LA ZONE FLOTTANTE

(30) Priorität: 15.02.2017 DE 102017202420
(43) Veröffentlichungstag der Anmeldung: 25.12.2019
(73) Patentinhaber: Siltronic AG, 81737 München (DE)
(72) Erfinder: SCHRÖCK, Thomas, 84556 Kastl (DE)
(74) Vertreter: Staudacher, Wolfgang
(86) Internationale Anmeldenummer: PCT/EP2018/053481
(87) Internationale Veröffentlichungsnummer: WO 2018/149798

(56) Entgegenhaltungen:
- WO-A1-2014/033212
- DE-A1-102010 040 464
- JP-A- H11 189 486
- JP-A- 2000 044 380
- JP-A- 2011 037 640

## Beschreibung

Die vorliegende Erfindung betrifft ein Verfahren zum Ziehen eines Einkristalls nach dem FZ-Verfahren, bei dem ein Polykristall mittels einer elektromagnetischen Schmelzvorrichtung aufgeschmolzen und anschließend wieder auskristallisiert wird, sowie eine entsprechende Anlage.

### Stand der Technik

Beim Ziehen von Einkristallen, insbesondere aus Halbleitermaterial, nach dem FZ-Verfahren, dem sogenannten Floating-Zone-Verfahren bzw. Zonenziehverfahren, können sehr reine Einkristalle erzeugt werden. Hierbei wird ein Polykristall, also insbesondere ein Kristall aus polykristallinem Halbleitermaterial, aufgeschmolzen und anschließend wieder auskristallisiert.

Bei einem solchen Verfahren können verschiedene Phasen unterschieden werden, wie sie beispielsweise in WO 2014/033212 A1 beschrieben werden. Der Polykristall wird hierbei zunächst aufgeschmolzen und dann an einem einkristallinen Impfling wieder auskristallisiert.

Dabei wird der Durchmesser des zu fertigenden Einkristalls von zunächst in etwa dem Durchmesser des Impflings in einem sog. Dünnhals-Abschnitt verkleinert und anschließend in einem konischen Abschnitt bis zu einem gewünschten Durchmesser geweitet. Dann kann der Durchmesser konstant gehalten werden, um beispielsweise einen stabförmigen Einkristall zu erhalten.

Weitere FZ-Verfahren sind in DE 102010040464 A1 und JP 2011037640 A offenbart.

Aus der JP 4 016 363 B2 ist beispielsweise ein FZ-Verfahren bekannt, bei dem unter Verwendung vier verschiedener Kameras verschiedene Bereiche des Polykristalls, des daran angebrachten Impflings sowie des dazwischen befindlichen flüssigen bzw. geschmolzenen Materials aufgenommen werden. Daraus wird dann neben Durchmessern des Polykristalls bzw. des Einkristalls eine Höhe des Bereichs bzw. der Zone des flüssigen bzw. geschmolzenen Materials, die sog. Zonenhöhe, ermittelt.

Bei einem solchen Verfahren und insbesondere zur Bildung des sog. Dünnhals-Abschnitts ist es wünschenswert, ein möglichst definiertes Volumen an Material am unteren Enden des Polykristalls aufzuschmelzen, das dann in Form eines Tropfens vorliegt bzw. am unteren Ende des Polykristalls hängt, um anschließend einen geeignet geformten Bereich auskristallisieren zu lassen, an den sich dann der erwähnte Dünnhals-Abschnitt anschließt.

Vor diesem Hintergrund stellt sich daher die Aufgabe, eine einfache und/oder genaue Möglichkeit zur Bildung eines Tropfens flüssigen Materials bestimmten Volumens an dem Polykristall zur Verfügung zu stellen, um so insbesondere eine Automatisierung des Prozesses zu ermöglichen.

### Offenbarung der Erfindung

Erfindungsgemäß werden ein Verfahren und eine Anlage zum Ziehen eines Einkristalls mit den Merkmalen der unabhängigen Patentansprüche vorgeschlagen. Vorteilhafte Ausgestaltungen sind Gegenstand der Unteransprüche sowie der nachfolgenden Beschreibung.

Die Erfindung geht aus von einem Verfahren zum Ziehen eines Einkristalls nach dem FZ-Verfahren, bei dem ein Polykristall mittels einer elektromagnetischen Schmelzvorrichtung aufgeschmolzen und anschließend wieder auskristallisiert wird. Als Material für den Polykristall und damit auch den zu fertigenden Einkristall kommt hier insbesondere ein Halbleitermaterial, bevorzugt Silizium, in Frage. Es versteht sich, dass das Material auch gewisse Unreinheiten oder Dotierungen enthalten kann.

In einer ersten Phase wird der Polykristall, der in aller Regel stabförmig mit einem Durchmesser von beispielsweise 160 mm ausgebildet ist, zunächst mittels einer Schmelzvorrichtung, beginnend an einem (in Bezug zur Schwerkraft bei vertikaler Anordnung des stabförmigen Polykristalls) unteren Ende, aufgeschmolzen. Als Schmelzvorrichtung kommt hier insbesondere ein Induktor bzw. eine Induktionsspule in Betracht. Hierbei kann durch Anregung mittels Hochfrequenz elektromagnetische Energie in den Polykristall, der in die Nähe des Induktors gebracht wird, eingekoppelt werden.

In der erwähnten ersten Phase kann der Polykristall, der an seinem unteren Ende in aller Regel konisch ausgebildet ist, ggf. mit einem flachen unteren Abschnitt, abgesenkt und an ein mittiges Loch im Induktor herangeführt werden. Um möglichst viel elektromagnetische Energie in den Polykristall einzukoppeln, ist es zweckmäßig, das untere Ende des Polykristalls an den Rand des Lochs zu bringen. Der Polykristall beginnt dann am unteren Ende zu schmelzen, wobei sich zunächst ein Tropfen flüssigen Materials bildet, der am Polykristall hängt.

In einer zweiten Phase wird nun ein einkristalliner Impfling, der insbesondere ebenfalls stabförmig ausgebildet ist und einen Durchmesser von beispielsweise ca. 4 bis 7 mm aufweist, an das untere Ende des Polykristalls und damit an den Tropfen flüssigen Materials, angebracht und dann beginnend von einem oberen Ende des Impflings an aufgeschmolzen. Das Aufschmelzen des Impflings beginnt dabei in der Regel erst, nachdem sich die Temperatur des Impflings an diejenige des bereits flüssigen Materials angeglichen hat. Der Impfling kann zweckmäßigerweise über einen gewissen Bereich seiner Länge, die beispielsweise zwischen 5 und 20 mm liegen kann, aufgeschmolzen werden. Es versteht sich jedoch, dass ein gewisser Bereich an seinem unteren Ende nicht aufgeschmolzen wird, da dieser zur Befestigung in einer Ziehvorrichtung benötigt wird. Zum Aufschmelzen des Impflings werden der Impfling und der Polykristall nach oben bewegt. Dies bedeutet beispielsweise, dass der Impfling in Richtung des Lochs des Induktors bewegt wird. Dabei wird ein Vorimpfling an dem unteren Ende des Polykristalls gebildet. Unter einem Vorimpfling ist dabei ein Bereich, insbesondere in Form eines Zapfens, am unteren Ende des Polykristalls zu verstehen, an dem dann der Impfling angebracht ist.

Insbesondere kann weiterhin in einer dritten Phase zwischen einem unteren Abschnitt des Impflings (an dem dieser beispielsweise in der erwähnten Ziehvorrichtung gehalten werden kann) und dem Polykristall (also dem noch festen und noch nicht geschmolzenen Anteil des Polykristalls) ein Dünnhals-Abschnitt gebildet werden, dessen Durchmesser geringer als derjenige des Impflings ist. Dieser Dünnhals-Abschnitt wird gebildet, um etwaige Versetzungen, die sich beispielsweise durch das Anbringen des Impflings an das flüssige Material am Polykristall bilden, zu entfernen. Der Durchmesser des Dünnhals-Abschnitts kann dabei beispielsweise zwischen 2 und 4 mm betragen. Zur Ausbildung dieses Dünnhals-Abschnitts können der Impfling und der Polykristall, nachdem der Impfling wie gewünscht aufgeschmolzen ist, wieder nach unten bewegt werden. Indem nun die Absenkgeschwindigkeit des Impflings erhöht wird, nimmt der Durchmesser der Zone flüssigen Materials bzw. des dann auskristallisierenden Materials aufgrund der Massenerhaltung ab.

Nach dem Dünnhals-Abschnitt kann dann der Durchmesser des Einkristalls bis zu einem gewünschten Durchmesser von beispielsweise ca. 200 mm erhöht und dann beibehalten werden.

Hierzu kann insbesondere in einer vierten Phase beim FZ-Verfahren nun zwischen dem Dünnhals-Abschnitt und dem Polykristall ein konischer Abschnitt gebildet werden. Ein solcher konischer Abschnitt dient dazu, den Durchmesser von demjenigen des Dünnhals-Abschnitts auf einen gewünschten Durchmesser zu weiten. Hierzu ist nun in aller Regel nötig, dass eine Absenkgeschwindigkeit des Impflings (zusammen mit dem bereits daran auskristallisierten Material) und des Polykristalls verändert werden, um den Durchmesser zu erhöhen. Insbesondere führt eine Reduzierung der Absenkgeschwindigkeit dazu, dass mehr Material auskristallisieren kann, wodurch der Durchmesser erhöht wird.

Erfindungsgemäß wird nun eine Leistung der Schmelzvorrichtung beginnend in der ersten Phase wenigstens zeitweise in Abhängigkeit von einer Temperatur und/oder geometrischen Abmessungen verwendeten Kristallmaterials, das den Tropfen und/oder den Impfling und/oder den Polykristall umfasst, vorgegeben. Während die geometrischen Abmessungen beispielsweise direkt mittels einer Kamera, die insbesondere oberhalb der Schmelzvorrichtung angeordnet sein kann, erfasst werden können, kann die Temperatur ermittelt werden, indem beispielsweise mit der erwähnten Kamera eine Helligkeit und/oder ein Spektrum des Materials, erfasst wird. Die Helligkeit stellt dabei ein Maß für die Temperatur dar. Während anhand der Temperatur des Materials eine Schmelzrate eingestellt werden kann, so kann anhand der geometrischen Abmessungen auf die Form und damit das Volumen des Tropfens geschlossen werden. Damit kann die Leistung der Schmelzvorrichtung also sehr einfach und sehr genau vorgegeben werden.

Zweckmäßig ist es insofern auch, die Leistung der Schmelzvorrichtung vor Erreichen einer vorbestimmten Temperatur des Polykristalls zu einem ersten Zeitpunkt zu erhöhen und nach Erreichen der vorbestimmten Temperatur des Polykristalls konstant zu halten, um so eine definierte Temperatur des Polykristalls einzustellen. Bevorzugt kann kurz nach Verwendung der konstanten Leistung diese dann weiter erhöht werden, beispielsweise gemäß einer Sollkurve, um den Polykristall weiter aufzuschmelzen. Der Wert der konstant gehaltenen Leistung kann auch gespeichert werden, um später als Referenzwert zur Verfügung zu stehen, von dem ausgehend die Leistung angepasst und so die Temperatur des Polykristalls gezielt verändert werden kann.

Die Leistung der Schmelzvorrichtung wird ab Erreichen vorbestimmter geometrischer Abmessungen des Tropfens zu einem zweiten Zeitpunkt reduziert, wobei die vorbestimmten geometrischen Abmessungen anhand einer in eine Form des Tropfens eingepassten geometrischen Form, nämlich eines gleichschenkligen Dreiecks, vorgegeben werden. Der niedrigste Punkt des Tropfens, also derjenige, der am weitesten vom noch festen Polykristall entfernt ist, wird dabei als Spitze des gleichschenkligen Dreiecks verwendet, während die Phasengrenze zwischen flüssigem und festem Material als Basis verwendet wird. Eine solche Einpassung ist mit geeigneter Bildverarbeitung sehr einfach zu handhaben. Die Abmessungen des Dreiecks wiederum stellen ein geeignetes Maß für das Volumen des Tropfens dar. Damit wird erreicht, dass der Tropfen nicht zu groß wird und sich von dem Polykristall lösen kann.

Nach dem Kontaktieren des Impflings mit dem Tropfen ist es von Vorteil, wenn die Leistung der Schmelzvorrichtung ab Erreichen einer vorbestimmten Temperatur des Impflings zu einem dritten Zeitpunkt reduziert wird. Dann kann nämlich davon ausgegangen werden, dass der Impfling nach der Kontaktierung ausreichend durchgeglüht ist. Die Temperatur des Impflings wird vorteilhafterweise mit Hilfe einer Kamera ermittelt, die unter der Schmelzvorrichtung angeordnet ist.

Die zu den erwähnten Zeitpunkten durchzuführenden Anpassungen der Leistung erfolgen dabei zweckmäßigerweise in der erwähnten Reihenfolge, d.h. der zweite Zeitpunkt liegt nach dem ersten Zeitpunkt und vor dem dritten Zeitpunkt.

Gegenstand der Erfindung ist weiterhin eine Anlage, die zur Durchführung des erfindungsgemäßen Verfahrens eingerichtet ist. Die Anlage weist hierzu eine Schmelzvorrichtung, wie sie beispielsweise bereits mehrfach erwähnt wurde, sowie eine geeignete Recheneinheit auf. Die Recheneinheit ist entsprechend eingerichtet, die einzelnen Verfahrensschritte durchzuführen und die Kameras entsprechend anzusteuern und deren Bilder auszuwerten.

Zur Vermeidung von Wiederholungen sei im Übrigen hinsichtlich weiterer Ausgestaltungen sowie der Vorteile der Anlage auf obige Erläuterungen zum erfindungsgemäßen Verfahren verwiesen.

Weitere Vorteile und Ausgestaltungen der Erfindung ergeben sich aus der Beschreibung und der beiliegenden Zeichnung.

Die Erfindung ist anhand eines Ausführungsbeispiels in der Zeichnung schematisch dargestellt und wird im Folgenden unter Bezugnahme auf die Zeichnung beschrieben.

### Figurenbeschreibung

Figur 1 zeigt schematisch einen Polykristall und eine Schmelzvorrichtung, womit ein erfindungsgemäßes Verfahren durchführbar ist.
Figur 2 zeigt die Schmelzvorrichtung aus Figur 1 in einer anderen Ansicht.
Figuren 3a bis 3f zeigen schematisch verschiedene Phasen eines erfindungsgemäßen Verfahrens in einer bevorzugten Ausführungsform.
Figuren 4a und 4b zeigen einen zeitlichen Ablauf eines erfindungsgemäßen Verfahrens in einer bevorzugten Ausführungsform.
Figur 5 zeigt ein unteres Ende des Polykristalls aus Figur 1 in einer detaillierteren Ansicht.

### Ausführungsform der Erfindung

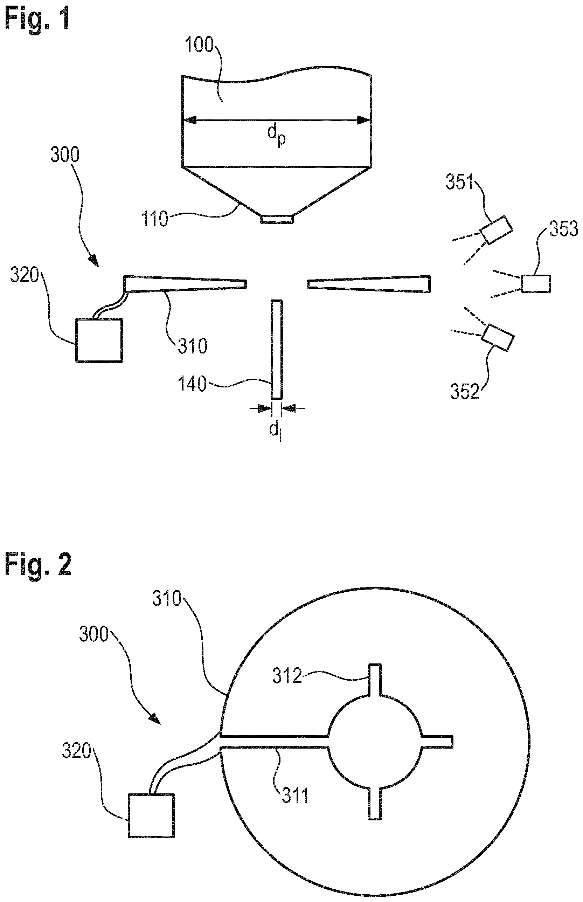

In Figur 1 sind schematisch ein Polykristall 100 und eine Schmelzvorrichtung 300, womit ein erfindungsgemäßes Verfahren durchführbar ist, in Seitenansicht dargestellt. Die Schmelzvorrichtung 300 weist hier einen Induktor bzw. eine Induktionsspule 310 auf, die mittels einer Ansteuereinheit 320, die über entsprechende Leitungen angeschlossen ist, beispielsweise mit Hochfrequenz entsprechend angesteuert bzw. betrieben werden kann.

Die Schmelzvorrichtung 300 ist dabei Teil einer Anlage, die zum Ziehen eines Einkristalls eingerichtet ist. Eine solche Anlage weist dann zudem entsprechende Halteeinrichtungen für den Induktor 300, den Einkristall 100 sowie die Kameras 351, 352 und 353 auf. Weiterhin weist eine solche Anlage eine Recheneinheit zum Steuern der übrigen Bestandteile auf.

Der Polykristall 100, der insbesondere Silizium aufweisen oder aus diesem bestehen kann, ist überwiegend stabförmig oder zylinderförmig ausgebildet. Im stab- bzw. zylinderförmigen Bereich, von dem hier nur ein Teil dargestellt ist, hat der Polykristall 100 einen Durchmesser dp, der beispielsweise 160 mm betragen kann. An seinem unteren Ende ist der Polykristall 100 jedoch konisch ausgebildet, d.h. er weist einen konischen Abschnitt 110 auf. Weiterhin ist zu sehen, dass der konische Abschnitt 110 wiederum ein flaches Ende an seinem unteren Ende aufweisen kann.

Sofern der Polykristall nicht mechanisch bearbeitet wurde, sondern beispielsweise aus einem - nicht zu Ende geführten - Schmelzvorgang stammt, so kann dieses untere Ende auch anders ausgebildet sein. Weiterhin ist ein Impfling 140 mit einem Durchmesser d_{I}, der beispielsweise 4 bis 7 mm betragen kann, zu sehen. Bei dem Impfling handelt es sich um einen Einkristall, der ebenfalls stab- bzw. zylinderförmig ausgebildet sein kann.

In Figur 2 ist die Schmelzvorrichtung 300 aus Figur 1 in einer anderen Ansicht, hier einer Draufsicht, dargestellt, allerdings ohne den Polykristall 100. Hier ist nun deutlich eine Ausnehmung bzw. ein Loch in der Mitte des Induktors 310 zu sehen, durch welches der Polykristall - während des Schmelzvorgangs und dann in verflüssigtem Zustand - hindurch geführt wird.

Insbesondere sind hier nun ein Hauptschlitz 311 sowie drei Nebenschlitze 312 zu sehen, die für die Funktion der Schmelzvorrichtung, insbesondere zur Erzeugung der elektromagnetischen Energie, von Vorteil sind. Wie zu sehen ist, ist der Induktor aufgrund des Hauptschlitzes 311 nicht geschlossen.

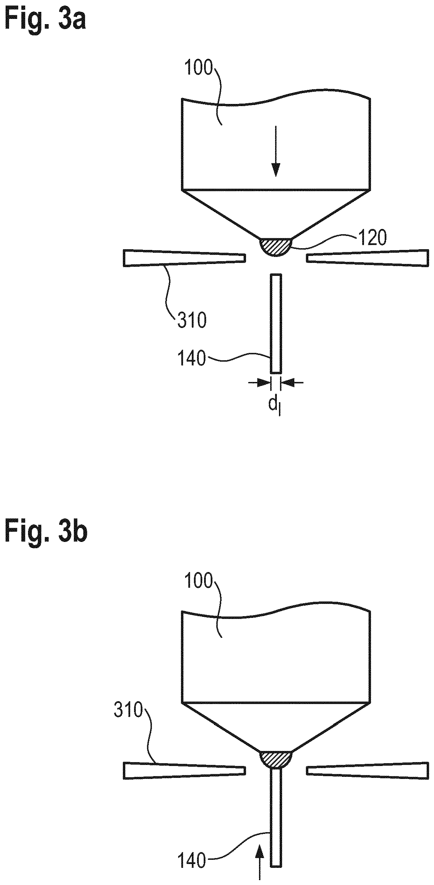

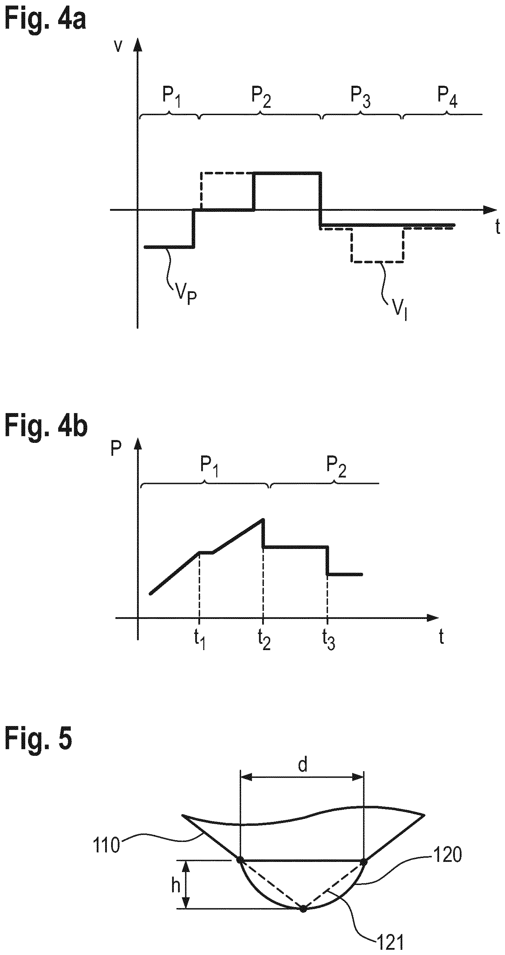

In den Figuren 3a bis 3f sind nun schematisch verschiedene Phasen eines erfindungsgemäßen Verfahrens in einer bevorzugten Ausführungsform dargestellt. Der Ablauf des Verfahrens soll im Folgenden anhand der Figuren 3a bis 3f sowie der Figuren 4a und 4b, die die Geschwindigkeiten v_{P} des Polykristalls und v_{I} des Impflings sowie eine Leistung P der Schmelzvorrichtung in einzelnen Phasen über der Zeit t zeigen, näher erläutert werden.

In einer ersten Phase P₁ wird der Polykristall 100 zunächst an den Induktor 310 bzw. die Ausnehmung in dessen Mitte herangeführt. Hierzu wird der Polykristall beispielsweise mit einer konstanten Geschwindigkeit abgesenkt. Der Impfling 140 muss hierbei noch nicht bewegt werden. Entgegen der hier gezeigten Ausrichtung kann der Polykristall 100 auch näher an einen inneren Rand des Induktors 310 herangeführt werden, um eine bessere Einkopplung der elektromagnetischen Energie in den Polykristall 100 zu ermöglichen.

Der Polykristall 100 beginnt damit an seinem unteren Ende, also auch dem unteren Ende des konischen Abschnitts, aufzuschmelzen. Hierbei bildet sich ein Tropfen 120 flüssigen Materials, der am Polykristall hängt, wie in Figur 3a zu sehen ist. Hier und in den folgenden Figuren ist flüssiges Material schraffiert dargestellt, während festes Material weiß bzw. ohne Schraffur dargestellt ist.

Eine Leistung P der Schmelzvorrichtung 300 wird hierbei zunächst erhöht und ab Erreichen einer vorbestimmten Temperatur des Polykristalls 100, in Figur 4b mit dem Zeitpunkt t₁ bezeichnet, konstant gehalten. Die Leistung kann dann erneut erhöht werden.

Sobald jedoch der Tropfen 120 eine vorbestimmte Form erreicht hat, was in Figur 4b mit dem Zeitpunkt t₂ bezeichnet ist, wird die Leistung wieder reduziert. Damit kann erreicht werden, dass der Tropfen nicht zu groß wird und sich vom Polykristall löst. Die Form kann dabei anhand geometrischer Abmessungen erkannt werden.

Hierzu sind in Figur 5 beispielhaft ein Durchmesser d des Tropfens 120 an der Phasengrenze zum konischen Abschnitt 110 sowie eine Höhe h als Abstand des (in der Figur) tiefsten Punktes des Tropfens über der Phasengrenze gezeigt. Hierzu sei angemerkt, dass der Tropfen 120 flüssigen Materials - im Gegensatz zu den anderen Figuren und der Übersichtlichkeit halber - nicht schraffiert dargestellt ist.

In einem von der entsprechenden Kamera erfassten Bild kann hier beispielsweise mittels geeigneter Bildverarbeitung ein gleichschenkliges Dreieck 121 mit den gezeigten Eckpunkten eingepasst werden, dessen Abmessungen einerseits die eben erwähnten geometrischen Abmessungen des Tropfens repräsentieren und andererseits auch ein Maß für das Volumen des Tropfens darstellen.

In einer zweiten Phase P₂ wird nun der Impfling 140 an das untere Ende des Polykristalls 100 und damit an den Tropfen 120 flüssigen Materials, angebracht, wie in Figur 3b zu sehen, und beginnend von einem oberen Ende des Impflings 140 aufgeschmolzen. Hierzu wird der Impfling zunächst beispielsweise mit einer bestimmten Geschwindigkeit auf den Polykristall 100 zu, also nach oben, bewegt, während sich der Polykristall 100 in Ruhe befinden kann. Das Aufschmelzen des Impflings 140 beginnt dabei in der Regel erst, nachdem sich die Temperatur des Impflings 140 an diejenige des bereits flüssigen Materials angeglichen hat.

Hierzu kann nun, wie in Figur 4b ab dem Zeitpunkt t₃ zu sehen, die Leistung der Schmelzvorrichtung wieder reduziert werden, sobald der Impfling 140 ausreichend durchgeglüht ist. Dies kann anhand der Temperatur des Impflings erkannt werden. Dabei ist die Helligkeit des festen Materials des Impflings und/oder das Spektrum ein bevorzugtes Maß für die Temperatur.

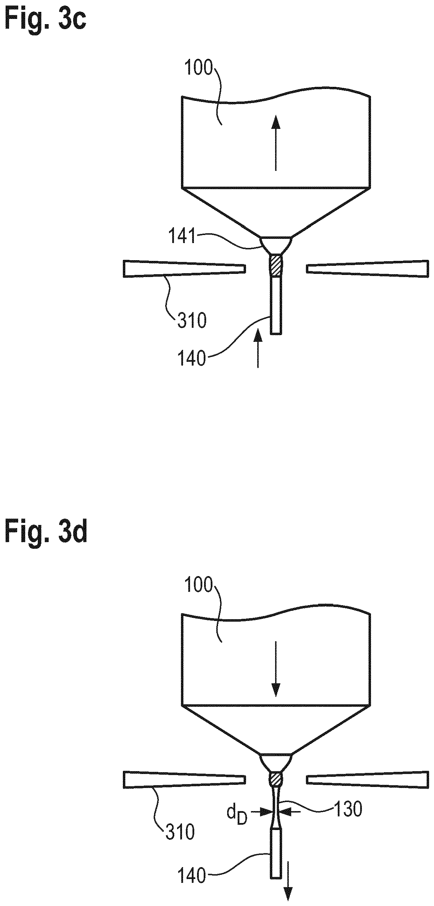

Nachdem nun der Impfling 140 an dem Tropfen flüssigen Materials am unteren Ende des Polykristalls 100 angebracht und damit verschmolzen ist, werden der Polykristall 100 und der Impfling 140 gemeinsam nach oben bewegt, wie in Figur 3c zu sehen. Dabei wird auch der Vorimpfling 141 an dem unteren Ende des Polykristalls 100 gebildet. Der Impfling kann dann über einen gewissen Bereich seiner Länge, beispielsweise zwischen 5 und 20 mm, aufgeschmolzen werden, indem der Impfling in Richtung des Lochs des Induktors 310 bewegt wird.

Es versteht sich jedoch, dass ein gewisser Bereich an dem unteren Ende des Impflings 140 nicht aufgeschmolzen wird, da dieser Abschnitt zur Befestigung in einer Ziehvorrichtung (als Teil der erwähnten Anlage) benötigt wird.

In einer dritten Phase P₃ wird nun zwischen einem unteren Abschnitt des Impflings 140 und dem Polykristall 100 (also dem noch festen und noch nicht geschmolzenen Anteil des Polykristalls) ein Dünnhals-Abschnitt 130 gebildet, dessen Durchmesser d_{D} mit beispielsweise 2 bis 4 mm geringer als derjenige des Impflings140 ist. Hierzu werden der Polykristall 100 und der Impfling 140 zunächst zugleich, d.h. mit gleicher Geschwindigkeit, nach unten bewegt.

Die Absenkgeschwindigkeit des Impflings 140 wird nun zu einem gewissen Zeitpunkt gegenüber derjenigen des Polykristalls 100 erhöht. Damit nimmt der Durchmesser der Zone flüssigen Materials bzw. des dann auskristallisierenden Materials aufgrund der Massenerhaltung ab. In Figur 3d ist beispielsweise bereits ein Dünnhals-Abschnitt 130 mit einer gewissen Länge gebildet.

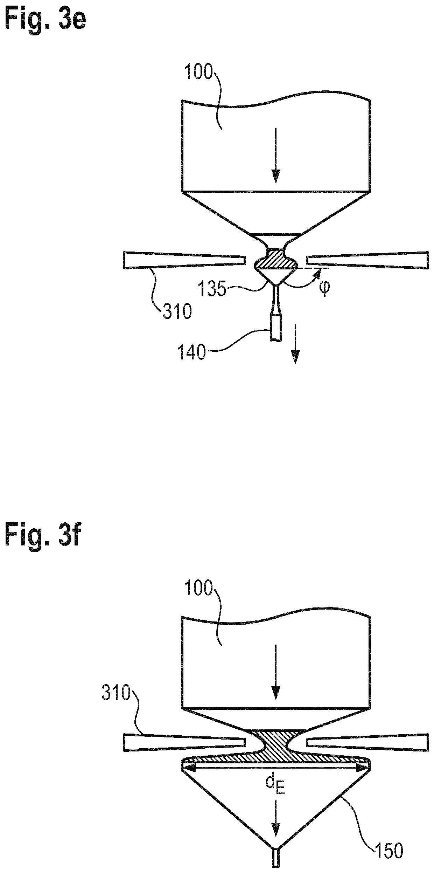

In einer vierten Phase P₄ kann nun zwischen dem Dünnhals-Abschnitt und dem Polykristall 100 ein konischer Abschnitt 135 mit einem Neigungswinkel ϕ gebildet werden, wie in Figur 3e zu sehen ist. Ein solcher konischer Abschnitt 135 dient dazu, den Durchmesser von demjenigen des Dünnhals-Abschnitts auf einen gewünschten Durchmesser d_{E} von beispielsweise 200 mm des zu fertigenden Einkristalls 150 zu weiten, wie in Figur 3f zu sehen ist.

## Patentansprüche

1. Verfahren zum Ziehen eines Einkristalls (150) nach dem FZ-Verfahren, bei dem ein Polykristall (100) mittels einer elektromagnetischen Schmelzvorrichtung (300) aufgeschmolzen und anschließend wieder auskristallisiert wird,
wobei in einer ersten Phase (P₁) ein unteres Ende des Polykristalls (100), der auf die Schmelzvorrichtung (300) zubewegt wird, mittels der Schmelzvorrichtung (300) unter Bildung eines Tropfens (120) aufgeschmolzen wird, und
wobei in einer zweiten Phase (P₂) ein einkristalliner Impfling (140) an das untere Ende des Polykristalls (100) angebracht und beginnend von einem oberen Ende des Impflings (140) an aufgeschmolzen wird,
**dadurch gekennzeichnet, dass** eine Leistung (P) der Schmelzvorrichtung (300) während der ersten Phase (P₁) und während der zweiten Phase (P₂) wenigstens zeitweise in Abhängigkeit von einer Temperatur und/oder den geometrischen Abmessungen (d, h) des verwendeten Kristallmaterials, das den Tropfen (120) und/oder den Impfling (140) und/oder den Polykristall (100) umfasst, vorgegeben wird, und
wobei die Leistung (P) der Schmelzvorrichtung (300) ab Erreichen vorbestimmter Abmessungen des Tropfens (120) während der ersten Phase (P₁) zu einem zweiten Zeitpunkt (t₂) reduziert wird, und die vorbestimmten Abmessungen anhand einer in eine Form des Tropfens (120) eingepasste Form eines gleichschenkligen Dreiecks vorgegeben werden, mit einem niedrigsten Punkt des Tropfens als Spitze und der Phasengrenze zwischen flüssigem und festem Material als Basis des gleichschenkligen Dreiecks.

2. Verfahren nach Anspruch 1, wobei während der ersten Phase (P₁) die Leistung (P) der Schmelzvorrichtung (300) vor Erreichen einer vorbestimmten Temperatur des Polykristalls (100) zu einem ersten Zeitpunkt (t₁) erhöht und nach Erreichen der vorbestimmten Temperatur des Polykristalls (100) konstant gehalten wird.

3. Verfahren nach Anspruch 2, wobei der Wert der konstant gehaltenen Leistung gespeichert wird.

4. Verfahren nach einem der vorstehenden Ansprüche, wobei während der zweiten Phase (P₂) die Leistung (P) der Schmelzvorrichtung (300) ab Erreichen einer vorbestimmten Temperatur des einkristallinen Impflings (140) zu einem dritten Zeitpunkt (t₃) reduziert wird.

5. Verfahren nach einem der vorstehenden Ansprüche, wobei eine Temperatur des verwendeten Kristallmaterials anhand einer Helligkeit und/oder eines Spektrums des verwendeten Kristallmaterials ermittelt wird.

6. Verfahren nach einem der vorstehenden Ansprüche, wobei die Temperatur und/oder die geometrischen Abmessungen des verwendeten Kristallmaterials unter Verwendung einer Kamera (351), die oberhalb der Schmelzvorrichtung (300) angeordnet ist, ermittelt werden.

7. Verfahren nach einem der Ansprüche 1 bis 5, wobei die Temperatur des einkristallinen Impflings (140) unter Verwendung einer Kamera (352), die unter der Schmelzvorrichtung (300) angeordnet ist, ermittelt wird.

8. Verfahren nach einem der vorstehenden Ansprüche, wobei weiterhin in einer dritten Phase (P₃) zwischen einem unteren Abschnitt des Impflings (140) und dem Polykristall (100) ein Dünnhals-Abschnitt (130) gebildet wird, dessen Durchmesser (d_{D}) geringer als derjenige (d_{I}) des Impflings (140) ist.

9. Verfahren nach einem der vorstehenden Ansprüche, wobei weiterhin in einer vierten Phase (P₄) zwischen dem Dünnhals-Abschnitt (130) und dem Polykristall (100) ein konischer Abschnitt (135) des Einkristalls gebildet wird.

10. Anlage zum Ziehen eines Einkristalls (150) nach dem FZ-Verfahren, umfassend eine Schmelzvorrichtung (300), Kameras zur Ermittlung von Temperatur und geometrischen Abmessungen und eine Rechnereinheit, **dadurch gekennzeichnet, dass** die Rechnereinheit eingerichtet ist, die Kameras anzusteuern und deren Bilder auszuwerten und die Verfahrensschritte des Verfahrens nach einem der Ansprüche 1 bis 9 durchzuführen.

## Claims

1. method for pulling a single crystal (150) according to the FZ method, in which a polycrystal (100) is melted by means of an electromagnetic melting device (300) and subsequently recrystallized,
wherein in a first phase (P1) a lower end of the polycrystal (100), which is moved towards the melting device (300), is melted by means of the melting device (300) to form a drop (120), and
wherein in a second phase (_{P2}), a single-crystalline seedling (140) is attached to the lower end of the polycrystal (100) and melted starting from an upper end of the seedling (140),
**characterized in that** a power (P) of the melting device (300) is predetermined during the first phase (P1) and during the second phase (P₂) at least temporarily as a function of a temperature and/or geometric dimensions (i.e.) of crystal material used comprising the drop (120) and/or the seed (140) and/or the polycrystal (100), wherein the power (P) of the melting device (300) is reduced at a second time (t2) after reaching predetermined dimensions of the gob (120) during the first phase (P1), and the predetermined dimensions are predetermined on the basis of an isosceles triangle shape fitted into a shape of the gob (120), with a lowest point of the gob as apex and the phase boundary between liquid and solid material as base of the isosceles triangle.

2. Method according to claim 1, wherein during the first phase (P1) the power (P) of the melting device (300) is increased before reaching a predetermined temperature of the polycrystal (100) at a first point in time (t1) and is kept constant after reaching the predetermined temperature of the polycrystal (100).

3. The method according to claim 2, wherein the value of the power held constant is stored.

4. Method according to one of the above claims, wherein during the second phase (P₂) the power (P) of the melting device (300) is reduced at a third time (t3) from the point at which the monocrystalline seed (140) reaches a predetermined temperature.

5. Method according to any of the foregoing claims, wherein a temperature of the crystal material used is determined from a brightness and/or a spectrum of the crystal material used.

6. Method according to any of the above claims, wherein the temperature and/or the geometrical dimensions of the crystal material used are determined using a camera (351) arranged above the melting device (300).

7. Method according to any one of claims 1 to 5, wherein the temperature of the single crystal seedling (140) is determined using a camera (352) disposed under the melting apparatus (300).

8. Method according to one of the above claims, wherein further in a third phase (P3) a thin neck portion (130) is formed between a lower portion of the seedling (140) and the polycrystal (100), the diameter (d_{D}) of which is smaller than that (d_{I}) of the seedling (140).

9. Method according to any of the above claims, wherein further in a fourth phase (P4) a conical portion (135) of the single crystal is formed between the thin neck portion (130) and the polycrystal (100).

10. Plant for pulling a single crystal (150) according to the FZ method, comprising a melting device (300), cameras for determining temperature and geometric dimensions and a computer unit, **characterized in that** the computer unit is set up to control the cameras and to evaluate their images and to carry out the process steps of the method according to one of claims 1 to 9.

## Revendications

1. méthode de tirage d'un monocristal (150) selon la méthode FZ, dans laquelle un polycristal (100) est fondu au moyen d'un dispositif de fusion électromagnétique (300) et ensuite recristallisé,
dans lequel, dans une première phase (P1), une extrémité inférieure du polycristal (100), qui est déplacée vers le dispositif de fusion (300), est fondue au moyen du dispositif de fusion (300) pour former une goutte (120), et
dans laquelle, dans une deuxième phase (P2), un plant monocristallin (140) est fixé à l'extrémité inférieure du polycristal (100) et fondu à partir d'une extrémité supérieure du plant (140),
**caractérisé en ce qu'**une puissance (P) du dispositif de fusion (300) est prédéterminée pendant la première phase (P1) et pendant la deuxième phase (P2) au moins temporairement en fonction d'une température et/ou des dimensions géométriques (c'est-à-dire) du matériau cristallin utilisé comprenant la goutte (120) et/ou le germe (140) et/ou le polycristal (100), dans lequel la puissance (P) du dispositif de fusion (300) est réduite à un second point dans le temps (t2) pour atteindre des dimensions prédéterminées de la paraison (120) pendant la première phase (P1), et les dimensions prédéterminées sont prédéterminées sur la base d'une forme de triangle isocèle adaptée à une forme de la paraison (120), avec un point le plus bas de la paraison comme sommet et la limite de phase entre le matériau liquide et solide comme base du triangle isocèle.

2. Procédé selon la revendication 1, dans lequel, pendant la première phase (P1), la puissance (P) du dispositif de fusion (300) est augmentée avant d'atteindre une température prédéterminée du polycristal (100) à un premier moment (t1) et est maintenue constante après avoir atteint la température prédéterminée du polycristal (100).

3. la méthode selon la revendication 2, dans laquelle la valeur de la puissance maintenue constante est stockée.

4. procédé selon l'une des revendications ci-dessus, dans lequel, pendant la deuxième phase (P2), la puissance (P) du dispositif de fusion (300) est réduite à un troisième temps (t3) à partir du point où le germe monocristallin (140) atteint une température prédéterminée.

5. une méthode selon l'une des revendications précédentes, dans laquelle une température du matériau cristallin utilisé est déterminée à partir d'une luminosité et/ou d'un spectre du matériau cristallin utilisé.

6. méthode selon l'une des revendications ci-dessus, dans laquelle la température et/ou les dimensions géométriques du matériau cristallin utilisé sont déterminées à l'aide d'une caméra (351) disposée au-dessus du dispositif de fusion (300).

7. une méthode selon l'une quelconque des revendications 1 à 5, dans laquelle la température du germe monocristallin (140) est déterminée à l'aide d'une caméra (352) disposée sous l'appareil de fusion (300).

8. procédé selon l'une des revendications ci-dessus, dans lequel en outre, dans une troisième phase (P3), une partie de col mince (130) est formée entre une partie inférieure du plant (140) et le polycristal (100), dont le diamètre (dD) est inférieur à celui (dI) du plant (140).

9. méthode selon l'une des revendications ci-dessus, dans laquelle en outre, dans une quatrième phase (P4), une partie conique (135) du monocristal est formée entre la partie de col mince (130) et le polycristal (100).

10. installation pour le tirage d'un monocristal (150) selon la méthode FZ, comprenant un dispositif de fusion (300), des caméras pour déterminer la température et les dimensions géométriques et une unité informatique, **caractérisée en ce que** l'unité informatique est conçue pour commander les caméras et pour évaluer leurs images et pour exécuter les étapes du procédé selon l'une des revendications 1 à 9.
